Europäisches Patentamt

European Patent Office

Office européen des brevets

(11) Publication number: **0 177 115**
**B1**

(12) **EUROPEAN PATENT SPECIFICATION**

(45) Date of publication of patent specification: **19.07.89**

(21) Application number: **85302833.0**

(22) Date of filing: **23.04.85**

(51) Int. Cl.⁴: **H 01 L 21/203, C 23 C 14/48, H 01 L 31/18, H 01 J 37/34**

(54) **Dual ion beam deposition of amorphous semiconductor films.**

(30) Priority: **04.09.84 US 647208**
**24.09.84 US 653168**

(43) Date of publication of application:
**09.04.86 Bulletin 86/15**

(45) Publication of the grant of the patent:
**19.07.89 Bulletin 89/29**

(84) Designated Contracting States:
**CH DE FR GB IT LI NL**

(56) References cited:
**DE-A-1 934 326**
**JP-A-59 170 270**
**US-A-4 376 688**
**US-A-4 416 755**
**JOURNAL OF NON-CRISTALLINE SOLIDS, vol. 59, vol. 60, part II, 1983, North-Holland Publishing Company-Amsterdam, C. COLUZZA et al. "a-Si:H produced by double ion-beam sputtering", pp. 723-726**

(73) Proprietor: **THE STANDARD OIL COMPANY**
**200 Public Square, 36-F-3454**
**Cleveland Ohio 44114-2375 (US)**

(72) Inventor: **Windischmann, Henry**
**36456 Churchill Drive**
**Solon, Ohio 44139 (US)**
Inventor: **Glocker, David A.**
**1451 Rush-Scottsville Road**
**Rush, New York 14543 (US)**
Inventor: **Miller, John R.**
**17800 Parkland Drive**
**Shaker Heights, Ohio 44122 (US)**
Inventor: **Grimshaw, Scott F.**
**RD No. 2 Box 362**
**Jordan New York 13080 (US)**

(74) Representative: **Jackson, Peter Arthur**
**GILL JENNINGS & EVERY 53-64 Chancery Lane**
**London WC2A 1HN (GB)**

Courier Press, Leamington Spa, England.

## Description

Amorphous semiconductor films having a sufficiently small density of localized states have been recognized as having many potential applications, including in photovoltaic devices. Hydrogen and fluorine have been recognized as effective in reducing the density of localized states, i.e., passivating, amorphous silicon films. With respect to hydrogen passivation of silicon, it has been found that the particular coordination of the hydrogen atoms with silicon atoms in hydrogenated amorphous silicon films (a-Si:H) has a dramatic effect on the electronic properties of those films. Films having the most desired electronic characteristics have large silicon monohydride concentrations relative to the concentration of polyhydrides. In fact, for electronic device quality material it is desired that only silicon monohydrides be present and that silicon polyhydrides be entirely absent from a-Si:H films.

Typically, hydrogenated amorphous silicon has a measured band gap energy of 1.7 to 1.8 eV meaning no electrical charge carriers can be generated in those films by photons having an energy less than that band gap energy. Therefore a significant amount of solar energy cannot be converted to electrical energy by amorphous, hydrogenated silicon films. On the other hand, if the band gap energy of a film is too low, the efficiency of the semiconductor film in generating charge carriers in response to incoming photons is reduced. Various semiconductor materials have band gap energies lower than that of amorphous silicon, but are unsuited for photovoltaic cells for numerous reasons, including the difficulty and expense of preparation. An ideal band gap energy, compromising efficiency of charge carrier generation and responsiveness to the energy range of photons present in solar illumination, is about 1.4 eV.

It is known that alloys of elemental semiconductors, i.e., compound semiconductors, having band gap energies intermediate those of the constituent elements can be prepared. For example, single crystal alloys of germanium and silicon have band gap energies between their elemental values (0.72 eV and 1.1 eV, respectively) depending upon the relative proportions of germanium and silicon in the alloy. The same band gap energy grading observed in crystalline alloys occurs in passivated amorphous compound semiconductor films, but amorphous semiconductor alloy films having satisfactory electronic properties have been difficult to prepare.

Numerous processes have been employed to produce a-Si:H films, but to date, none have reliably controlled the coordination of passivating atoms with the semiconductor atoms in the films. Among the deposition techniques that have been used are glow discharge and radio frequency and reactive gas sputtering. An example of sputtering using a single ion gun is disclosed in U.S. Patent 4,376,688 to Caesar et al. Dual ion beam sputtering was reported by Coluzza and others in an article "a-Si:H Produced by Double Ion-Beam Sputtering" in 59 & 60 Journal of Non-Crystalline Solids, 723—726 (1983). In that article, the authors disclosed directing a sputtering (argon) beam at a silicon target and a passivating beam of (hydrogen) at the substrate on which the sputtered amorphous silicon was condensed. The published results indicated that no improvement was achieved in reliably controlling the amount and form of hydrogen content of the film deposited by the Coluzza et al. dual ion beam sputtering technique.

In the invention, the problem of controlling the type of hydrogen-semiconductor bonding to produce electronic quality amorphous silicon and amorphous compound semiconductor films by sputtering is solved. Control of the bonding to maximize monohydride concentration relative to the polyhydride concentration is achieved by use of separate sputtering ion and hydrogen ion beams both directed at the sputtering target. The use of different beams permits independent control of the energies of the two types of ions. By controlling the energy of the passivating ions, the type of bonds formed between the semiconductor ions and passivating ions can be controlled.

The deposited films may be doped by injecting a gaseous dopant, such as phosphine or diborane, into the source or sources producing the passivating ion beams. The deposition process may be enhanced by illuminating the substrate with ultraviolet light, by heating the substrate and/or by bombarding the substrate with ions or electrons during the deposition.

The invention can be understood more clearly by reference to the drawing figures taken in conjunction with the detailed description that follows.

Fig. 1 shows in schematic form a cross-sectional view of an apparatus that may be used to deposit elemental semiconductor films according to the invention.

Fig. 2 shows relative, representative plots of the measured absorption spectra of two elemental semiconductor sample films, one of which was prepared according to the inventive process.

Fig. 3 is a least squares plot of the measured bonded hydrogen concentration as a function of substrate temperature and hydrogen ion beam current for elemental semiconductor films prepared according to the invention.

Fig. 4 is a least squares plot of the logarithm of the measured photoconductivity of elemental semiconductor films prepared both according to the inventive process and with substrate bombardment by hydrogen ions for a fixed substrate temperature, as a function of argon ion beam current and hydrogen ion beam voltage.

Fig. 5 is a plot of dark conductivity as a function of the reciprocal of temperature for an elemental semiconductor film prepared according to the inventive process.

Fig. 6 is a schematic cross-sectional view of an apparatus that may be used to deposit compound semiconductor films according to the invention.

Fig. 7 is a schematic cross-sectional view of an apparatus that may be used to deposit compound semiconductor films according to the invention.

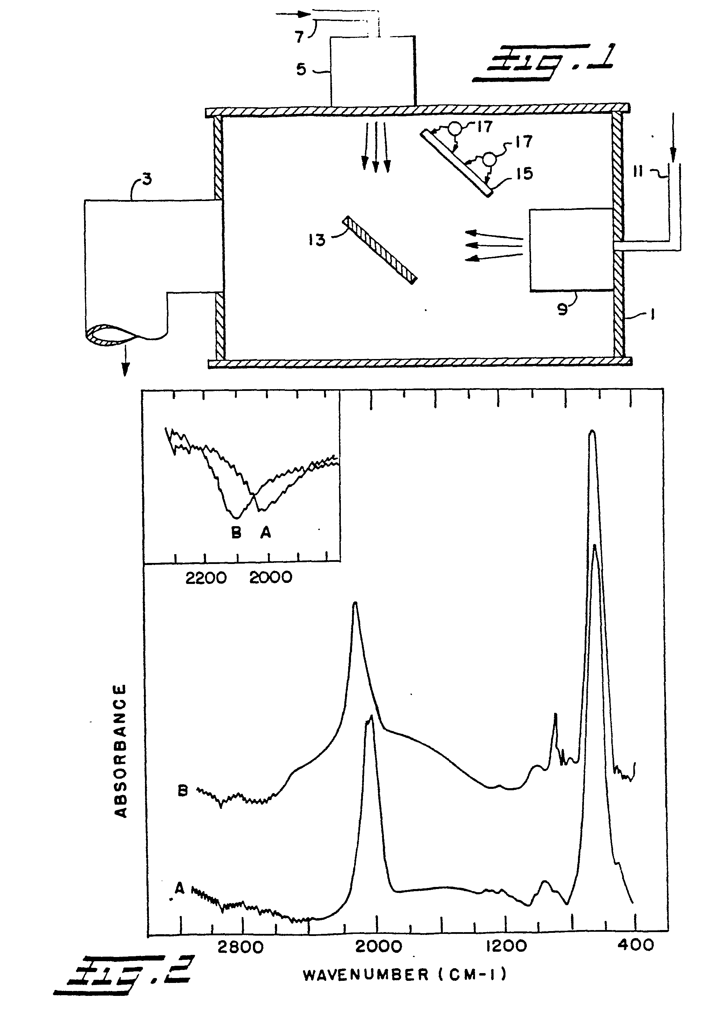

Apparatus for carrying out one embodiment of the inventive process is shown schematically in Fig. 1. A vacuum chamber 1 is evacuated by a vacuum system 3. In our work we used a steel vacuum chamber 48 cm in diameter pumped by a liquid nitrogen-trapped diffusion pump having an ultimate pressure of $6.66 \times 10^{-5}$ pascal. Chamber 1 is fitted with a first ion source 5 that can produce an ion beam within the chamber. Ion source 5 includes a gas inlet 7 which in our work was connected to a source of argon. A second ion source 9 is also fitted to chamber 1 to produce a second ion beam. Ion source 9 has a source 11 of a passivating gas connected to it for production of a beam of passivating ions effective in passivating localized states in amorphous semiconductor films. We used hydrogen as a passivating gas, but fluorine and other atomic species are also known to be effective.

In a preferred embodiment of the apparatus for performing the inventive process, ion sources 5 and 9 are conventional Kaufman type ion sources in which a plasma is created in the gas entering the source. The ions extracted from the gas in the plasma are directed out of the source and accelerated by an accelerator grid charged with a negative potential. A second or screen grid may also be present to suppress secondary emissions from the accelerator grid. We used sources 2.5 cm in diameter to form each ion beam. Argon was used with source 5 to produce relatively heavy ions that are effective in sputtering a silicon or other elemental semiconductor target. Other gases producing relatively heavy ions may be used instead of argon. In our apparatus, dual graphite grids were used to accelerate the argon ion beam and screen the accelerator grid. Ion source 9 may use a graphite grid or, if the sputtering potential of the gas used is low, as with hydrogen, a metal grid may be used. We used a single nickel accelerator grid for a hydrogen ion source.

Within chamber 1, a sputtering target 13 is mounted by conventional means. The ion beams from sources 5 and 9 are directed to impinge on target 13. In our work, sputter target 13 was a 12.5 cm diameter, 99.9999% pure silicon wafer. That target was water-cooled by conventional means.

One or more substrates 15 are mounted within chamber 1 opposing target 13 to collect the material sputtered from it. Substrates 15 are remotely placed to avoid being sputtered themselves and to avoid collection of undesired sputtering products. Substrates 15 may be heated by a thermal source such as quartz lamps 17. In our apparatus, three substrates were used: fused silica, 7059 Corning glass and single crystal silicon. Substrates may also be metallic such as stainless steel. The substrates were mounted against a copper backing plate to spread heat evenly. The backing plate was mounted in a stainless steel holder.

In our procedure, chamber 1 was evacuated to 1.33 to $2.7 \times 10^{-4}$ pascal and the temperatures of the substrates were allowed to stabilize for at least one hour. All gases delivered to the ion sources were research grade and the gas lines were purged for 15 minutes before sputtering began. Flow rates to the ion sources were adjusted to produce partial argon and hydrogen pressures of $2.3 \times 10^{-2}$ and $8.8 \times 10^{-2}$ pascal, respectively. This hydrogen pressure corresponded to a flow rate of 20 sccm. Sputtered films were cooled to at least 75°C before the venting of chamber 1. Film thicknesses ranged between 0.7 and 1 micrometers and were measured by profilometer. The type of hydrogen bonding in the films was determined from their Fourier transform infrared (FTIR) absorption spectra. Atomic hydrogen content was calculated from the spectra measured in the vicinity of 640 cm$^{-1}$ using the method of Brodsky, et al. published in *Physical Review* B16, 3556 (1977).

In our work the currents of the ion beams (argon: 20, 35, 50 mA; hydrogen: 20, 40, 60 mA), and the hydrogen ion beam energy (100, 150, 200 eV) were varied. In addition, in some of our tests, the substrates, instead of the target, were bombarded with hydrogen ions and, in some of those tests, krypton was mixed with hydrogen in the second ion source. In some tests, the substrates were illuminated with ultraviolet light. The substrate temperature (100, 200, 300°C) was also varied.

The hydrogenated, elemental amorphous silicon films deposited by the inventive technique are of good physical quality. They are smooth and clear, ranging from red to yellow in color. No columnar growth was observed in scanning electron microscope examination of fractured samples, even after etching in potassium hydroxide.

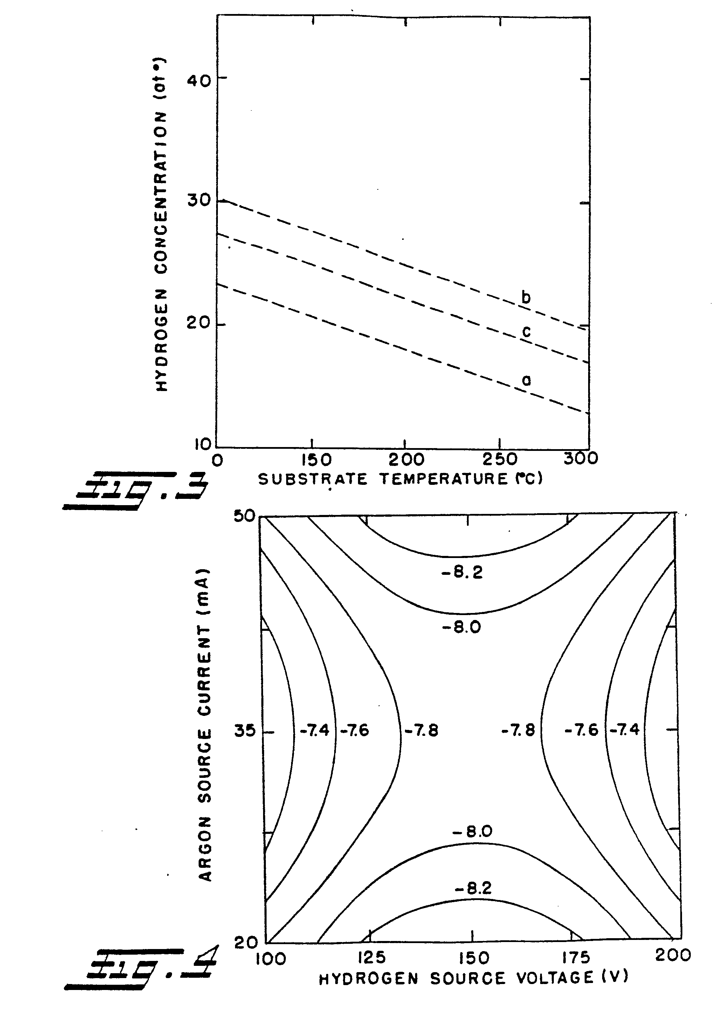

Fig. 2 shows representative plots of the measured FTIR absorption spectra for two samples. The spectrum curve plotted lower and marked as A was measured from an a-Si:H film prepared according to the invention. The upper spectrum curve designated B was measured from an a-Si:H film prepared by directing the hydrogen ion beam of source 9 to strike the substrates instead of the target. Absorption lines for silicon monohydride and polyhydrides exist at 2000 and 2090 cm$^{-1}$, respectively. The percentage of each bonding configuration was estimated from the relative absorbance maxima of these two lines. Polyhydrides also have bending modes at 840 and 890 cm$^{-1}$ and the presence of such lines indicates the presence of polyhydrides. Curve B of Fig. 2 clearly shows an increase at 2090 cm$^{-1}$ that is not present in curve A. Likewise, the polyhydride bending mode lines are clearly present in curve B, but not curve A. From such spectral measurements it was determined that films prepared according to the invention, i.e., in which the hydrogen ion beam was directed at the sputtering target, were free of polyhydrides. The inset in Fig. 2 shows a higher resolution scan in the range from 2000 to 2100 cm$^{-1}$. These scans show very clearly the presence of the 2090 cm$^{-1}$ line in sample B indicating the presence of polyhydrides, and its absence in sample A that was prepared according the inventive process.

# EP 0 177 115 B1

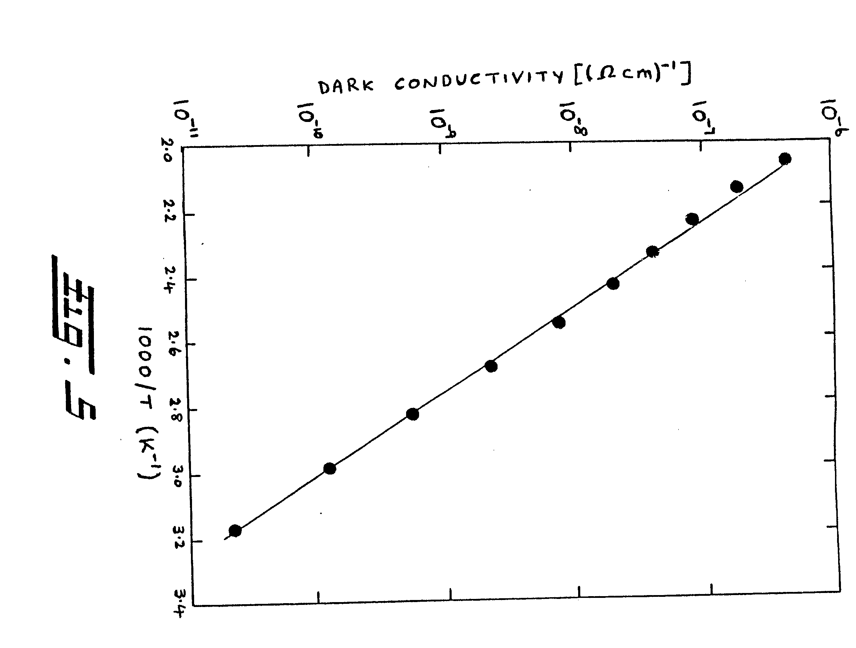

The total measured atomic percent of bonded hydrogen in films we prepared is illustrated in Fig. 3. There, a least squares fit of the measured percentage of total bonded hydrogen present in films prepared according to the invention is plotted against substrate temperatures for different hydrogen ion beam currents (a=20 mA, b=40 mA, c=60 mA). In the plotted results, all hydrogen was bound as monohydride regardless of the quantity of hydrogen present.

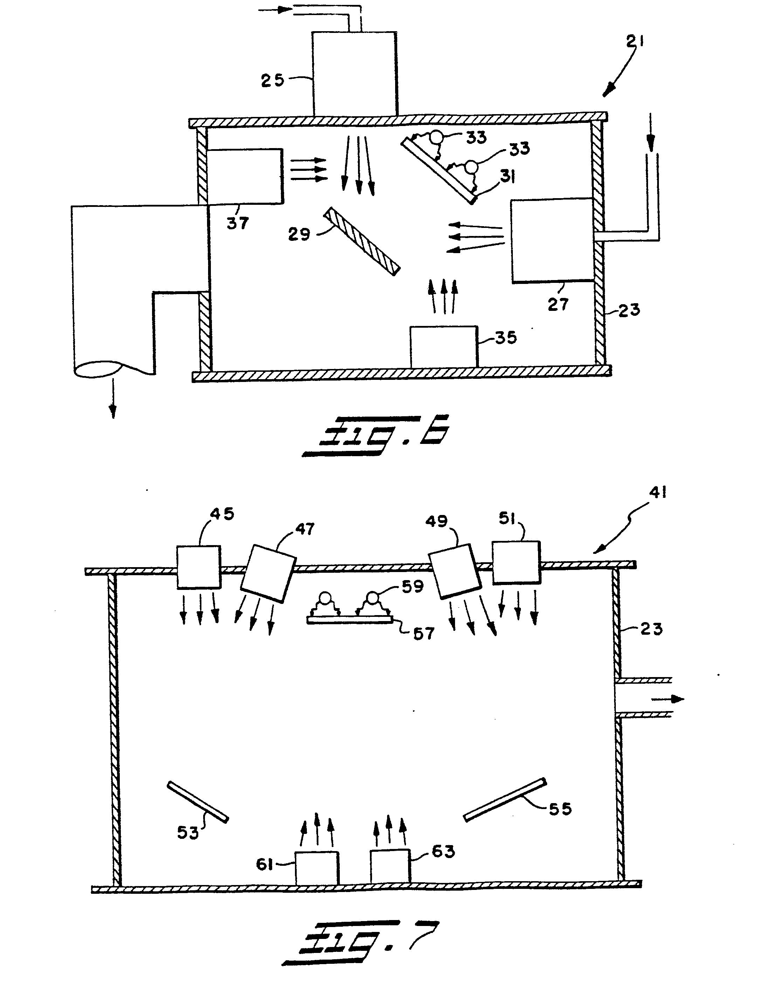

The photoconductivity of the films, $\rho_p$, is defined as the difference between the conductivity of films measured under light of intensity of 100 mW/cm$^2$, and the conductivity in darkness, $\rho_D$. The photoconductivity of elemental, amorphous silicon films deposited on fused silica substrates both according to the inventive process and with hydrogen ions directed at the substrate, was measured using painted carbon contacts. These contacts were tested and determined to be ohmic. Hydrogen beam voltage, argon beam current and substrate temperature were the most significant variables affecting the measured photoconductivity of films prepared according to both processes. A least squares fit of the logarithm of the measured photoconductivity of films prepared according to both processes at a substrate temperature of 300°C, is plotted in Fig. 4 as a function of argon ion beam current and the voltage used to accelerate the hydrogen ion beam. We found that for the conditions that we used that photoconductivity is maximized at a hydrogen ion acceleration voltage of 150 volts and ion current of 35 mA. These conditions appear as a saddle point on the graph of Fig. 4.

In Fig. 5, the logarithm of the dark conductivity of a hydrogenated elemental amorphous silicon film prepared according to the inventive process is plotted as a function of the reciprocal of temperature. The plot shows a single activation energy further confirming that only monohydrides are present in films prepared according to the invention.

The characteristics of elemental hydrogenated amorphous silicon films deposited according to the inventive process under varying conditions are listed in Table 1 for tests 1, 2, 3, 4, 7, 8, 9 and 10. Tests 5 and 6 are also listed to show results when the hydrogen beam was directed at the substrates rather than at the sputtering target. In the Table, the following measured test conditions and measured results are listed: argon ion beam current, hydrogen ion beam current, hydrogen ion acceleration voltage, substrate temperature, the direction of the hydrogen passivating ion beam at the (sputtering target or at the substrate), presence or absence of ultraviolet illumination of the substrates, measured percentage of silicon monohydride in the deposited film, atomic percentage of hydrogen in the deposited film, and the measured logarithms of the dark conductivity and of the photoconductivity of the deposited films. The final column in Table 1 lists the activation energy for amorphous hydrogenated elemental silicon films prepared according to the inventive process as measured by the technique producing the results plotted in Fig. 5. Entries of N.A. mean that no single activation energy was measured and that the measured plot was non-linear. As indicated in the Table, a single activation energy was found for all but one filmn prepared according to the inventive process. Test 9 produced an anomalous, non-linear result having no single activation energy. By contrast, the activation energy plots of films made during hydrogen ion bombardment of the substrates were always non-linear.

TABLE 1

| Test No. | Ar curr. (mA) | H curr. (mA) | H volt. (V) | $T_s$ (°C) | H Dir. | UV | % SiH | At% H | log $\sigma_D$ | log $\sigma_p$ | E (eV) |
|---|---|---|---|---|---|---|---|---|---|---|---|
| 1 | 20 | 60 | 200 | 300 | Tar. | Off | 100 | 20 | −11.4 | −7.9 | 0.95 |
| 2 | 50 | 20 | 200 | 100 | Tar. | On | 100 | 23 | −9.2 | −8.6 | 0.89 |
| 3 | 50 | 60 | 100 | 100 | Tar. | On | 100 | 27 | −10.4 | −8.7 | 0.75 |
| 4 | 20 | 20 | 150 | 200 | Tar. | On | 100 | 23 | −11.0 | −9.7 | 0.77 |
| 5 | 35 | 60 | 200 | 200 | Sub. | On | 20 | 36 | −11.0 | −9.1 | N.A. |
| 6 | 50 | 20 | 200 | 100 | Sub. | Off | 0 | 45 | −11.4 | −9.3 | N.A. |
| 7 | 35 | 40 | 100 | 300 | Tar. | On | 100 | 19 | −10.6 | −7.2 | 1.0 |
| 8 | 50 | 20 | 100 | 100 | Tar. | Off | 100 | 23 | −9.5 | −8.6 | 0.66 |
| 9 | 35 | 40 | 200 | 300 | Tar. | Off | 100 | 22 | −10.5 | −6.8 | N.A. |
| 10 | 50 | 60 | 200 | 100 | Tar. | On | 100 | 40 | −10.3 | −8.2 | 0.76 |

The precise mechanism in the process that produces the desired results is not completely understood. It appears to us that in the deposition of hydrogenated amorphous silicon, silicon polyhydride is formed at the target and that reactive hydrogen, along with silicon, is sputtered onto the substrate. We believe that polyhydide formation in deposited films is primarily the result of large amounts of reactive hydrogen being present at the film surface during film growth. Therefore, conditions that favor polyhydride formation at the sputtering target and reduce the concentration of atomic hydrogen at the substrate, result in an increase of monohydride content in sputtered films.

The inventive process is not limited to use with silicon to produce elemental hydrogenated, amorphous semiconductor films with a reduced density of localized states, but may also be used with other group IVa elements from the periodic table, such as germanium and appropriate passivating atoms, such as hydrogen or fluorine, to produce high quality amorphous semiconducting films.

In addition, the inventive process may be used to deposit compound semiconductor passivated films, that is, films containing an alloy of two or more semiconductor elements, plus passivating atoms for reducing the density of localized states. By alloying semiconductor elements, a film having a desired, preselected band gap energy can be produced. An apparatus 21 for producing such compound semiconductor passivated films is shown in schematic cross sectional view in Fig. 6. Apparatus 21 contains many of the same elements as the apparatus of Fig. 1. A vacuum vessel 23 is fitted with two ion sources 25 and 27, which may be conventional Kaufman sources. Ion source 25 is supplied with a sputtering gas, such as argon; source 27 is supplied with a passivating gas, such as hydrogen or a halogen. The beams from ion sources 25 and 27 are directed toward a single sputter target 29 that is water-cooled. Target 29 is composed of a substantially pure alloy of elemental semiconductors such as germanium and silicon. Target 29 may be crystalline or polycrystalline.

The material sputtered from target 29 is collected on a substrate 31 that is located remotely from the ion beams and target to avoid collection of inadvertently sputtered material and to avoid sputtering of the substrate. The temperature of substrate 31 may be elevated by a heat source which may be quartz lamps 33. A source of ultraviolet light 35 may be used to illuminate substrate 31 and an electron source 37 may bombard substrate 31. During deposition, substrate 31 may be heated, illuminated with ultraviolet light and bombarded with electrons, independently or in any combination, to enhance the deposition process. Substrate 31 may be a glass, a semiconductor or a metal such as stainless steel.

By varying the current and energy of the two ion beams separately, the rate of sputtering of target 29 and the passivating atom content of the sputtered products can be independently controlled. As noted above, this feature of the inventive process is particularly important since it is known that the particular coordination of the hydrogen atoms with the semiconductor atoms in hydrogenated amorphous films has a dramatic effect on the electronic properties of the film.

Another apparatus 41 for an application of the inventive process is shown in schematic cross-sectional form in Fig. 7. A vacuum vessel 23 is fitted with four ion sources 45, 47, 49 and 51. Ion sources 45 and 47 are directed at a sputter target 53 which is preferably an elemental semiconductor such as silicon or germanium. Ion source 45 is supplied with a sputtering gas, such as argon, to produce a beam of ions that sputter material from target 53. Source 47 is supplied with a passivating gas to produce a beam of passivating ions that impinge on target 53. Ion sources 49 and 51 are entirely analogous to sources 45 and 47, except that they are directed at another sputter target 55. That target 55 is an elemental semiconductor, such as silicon or germanium, different from the composition of target 53. The deposited alloy will be composed of the materials comprising the two targets 53 and 55. Both targets are water-cooled and are of high purity.

The materials sputtered from targets 53 and 55 are collected on a substrate 57. Substrate 57 is located remotely from the four ion beams and the two targets to avoid collection of inadvertently sputtered material and to avoid sputtering of the substrate. The temperature of the substrate may be elevated by a heat source which may be quartz lamps 59. An ultraviolet light source 61 and electron source 63 are also provided to illuminate and bombard substrate 57 during deposition, if desired. As noted for the other application described, the substrates may be heated, illuminated with ultraviolet light and bombarded with electrons, or any combination of them to enhance the deposition process. The substrate may be a glass, including fused silica, a semiconductor such as silicon, or may be metallic, such as a stainless steel.

By varying the currents and energies of the four ion beams used in this application of the inventive process, the rate of sputtering of the respective targets, the composition of the deposited alloy film and the passivating atom content of the sputter products can be carefully controlled. This extreme degree of control is of great importance since the alloy composition and, in our work, the content and bonding of the passivating atoms in the film, has a very substantial effect upon the electronic properties of the film.

By using either of the two embodiments of the inventive process just described, a continuum of compositions of passivated ternary alloys, such as $Si_xGe_{1-x}(H)$, where x ranges between 0 and 1, can be produced.

Films deposited according to any of the described embodiments of the inventive process may be doped during deposition by adding a gaseous dopant to the passivating ion beam source. Phosphine may be ionized to produce phosphorous ions for preparing n-type material and diborane may be ionized to boron ions for preparing p-type material. By changing dopants during deposition, junction devices such as p-n and p-i-n structures can be formed in the films. In the embodiments described for depositing amorphous compound semiconductor films, there is a choice of passivating ion sources and the same dopant need not be supplied to each.

## Claims

1. A process for depositing a hydrogenated amorphous semiconductor film on a substrate, the process comprising simultaneously directing first and second ion beams, produced by first (5, 25, 45) and second (9, 27, 47) ion sources, respectively, against a first target (13, 29, 53) of a semiconductor material that is to be included in the film, the first ion beam including sputtering ions to sputter material from the first target and the second beam including hydrogen ions to reduce the density of localized states in the deposited films, collecting sputtering products from the first target on the substrate (15, 31, 57), and independently controlling the relative energies and currents of ions in the first and second beams so that the sputtering ions are effective in sputtering semiconductor material from the target and so that the energy of the hydrogen ions in the second ion beam does not exceed 200 electron volts.

2. A process according to claim 1, characterised in that, while directing the first and second ion beams at the first target, simultaneously directing third and fourth ion beams, produced by third (49) and fourth (51) ion sources, respectively, against a second target (55) of semiconductor material that is to be included in the film, the second target being of a different composition from the first target, the third ion beam including sputtering ions to sputter the material from the second target, and the fourth beam including hydrogen ions to reduce the density of localised states in the deposited films, independently controlling the relative energies and currents of the ions in the third and fourth beams so that the sputtering ions are effective in sputtering semiconductor material from the second target and so that the energy of the hydrogen ions in the fourth beam does not exceed 200 electron volts, and collecting sputtering products from the first and second targets on the substrate.

3. A process according to claim 1 or claim 2, characterised in that the sputtering ions comprise argon ions.

4. A process according to claim 3, characterised in that the sputtering ion beam or at least one of the sputtering ion beams, has a current of between 20 and 50 milliamperes.

5. A process according to claim 1 or claim 2, characterised in that the first target comprises substantially pure silicon.

6. A process according to claim 5, characterised in that the hydrogen ion beam or at least one of the hydrogen ion beams, has a current of between 20 and 60 milliamperes.

7. A process according to claim 5 or claim 6, characterised by elevating the temperature of the substrate to between 100°C and 300°C.

8. A process according to claim 1, characterised in that the first target comprises an alloy of at least two elemental semiconductors that are to be deposited as the film.

9. A process according to claim 8, characterised in that the first target comprises a substantially pure alloy of silicon and germanium.

10. A process according to claim 2, wherein the first target is substantially pure germanium and the second target is substantially pure silicon.

11. A process according to claim 1 or claim 2, wherein the first target comprises an element from group IVa of the periodic table.

12. A process according to claim 1 or claim 2, characterised by illuminating the substrate with ultraviolet light.

13. A process according to claim 1 or claim 2, characterised by irradiating the substrate with electrons.

14. A process according to any one of the preceding claims, characterised in that the second ion source produces a beam including dopant ions.

15. A process according to claim 14, characterised in that the dopant ions consist of boron or phosphorus ions.

## Patentansprüche

1. Verfahren zum Niederschlagen eines hydrierten amorphen Halbleiterfilms auf einem Substrat, dadurch gekennzeichnet, daß gleichzeitig ein erster Ionenstrahl und ein zweiter Ionenstrahl jeweils von einer ersten Ionenquelle (5, 25, 45) bzw. einer zweiten Ionenquelle (9, 27, 47) gegen ein erstes Target (13, 29, 53) für ein in den Film einzuschließendes Halbleitermaterial gerichtet wird, wobei der erste Ionenstrahl Zerstäubungsionen enthält, um Material aus dem ersten Target zu zerstäuben, und der zweite Ionenstrahl Wasserstoffionen enthält, um die örtliche Niveaudichte in den niedergeschlagenen Filmen zu vermindern, Zerstäubungsprodukte aus dem ersten Target auf dem Substrat (15, 31, 57) gesammelt werden und unabhängig die relativen Energien und Stromstärken von Ionen im ersten und im zweiten Ionenstrahl kontrolliert werden, so daß die zerstäubungsionen im Zerstäubungshalbleitermaterial des Targets wirksam sind und die Energ der Wasserstoffionen im zweiten Ionenstrahl 200 eV nicht übersteigen.

2. Verfahren gemäß Anspruch 1, dadurch gekennzeichnet, daß während der erste und der zweite Ionenstrahl auf das erste Target geleitet werden, gleichzeitig ein dritter und ein vierter Ionenstrahl, die durch eine dritte Ionenquelle (49) bzw. eine vierte Ionenquelle (51) gebildet sind, gegen ein zweites Target (55) des Halbleitermaterials geleitet werden, das Teil des Films sein soll, wobei das zweite Target eine andersartige Zusammensetzung als das erste Target hat, der dritte Ionenstrahl Zerstäubungsionen enthält, um das Material au dem zweiten Target zu zerstäuben, und der vierte Ionenstrahl Wasserstoffionen enthält, um die örtliche Niveaudichte im niedergeschlagenen Film zu reduzieren und dabei unabhängig die relativen Energien und Stromstärken der Ionen im dritten und im vierten Ionenstrahl kontrolliert werden, so daß die Zerstäubungsionen beim Zerstäuben von Halbleitermaterial aus dem zweiten Target wirksam werden und die Energie der Wasserstoffionen im vierten Ionenstrom 200 eV nicht überschreitet und dabei Zerstäubungsmaterial aus dem ersten und dem zweiten Target auf dem Substrat gesammelt werden.

3. Verfahren gemäß Anspruch 1 oder 2, dadurch gekennzeichnet, daß die Zerstäubungsionen Argonionen umfassen.

4. Verfahren gemäß Anspruch 3, dadurch gekennzeichnet, daß der Zerstäubungsionenstrahl oder zumindest einer der Zerstäubungsionenstrahlen eine Stromstärke zwischen 20 und 50 Milliampere hat.

5. Verfahren gemäß Anspruch 1 oder 2, dadurch gekennzeichnet, daß das erste Target im wesentlichen aus reinem Silizium ist.

6. Verfahren gemäß Anspruch 5, dadurch gekennzeichnet, daß der Wasserstoffionenstrahl oder mindestens einer der Wasserstoffionenstrahlen eine Stromstärke zwischen 20 und 60 Milliampere hat.

7. Verfahren gemäß Anspruch 5 oder 6, dadurch gekennzeichnet, daß die Temperatur des Substrats auf zwischen 100°C und 300°C erhöht wird.

8. Verfahren gemäß Anspruch 1, dadurch gekennzeichnet, daß das erste Target einer Legierung aus mindestens zwei Halbleiterelementen ist, die als Film niedergeschlagen werden soll.

9. Verfahren gemäß Anspruch 8, dadurch gekennzeichnet, daß das erste Target aus einer im wesentlichen reinen Legierung aus Silizium und Germanium ist.

10. Verfahren gemäß Anspruch 2, dadurch gekennzeichnet, daß das erste Target aus im wesentlichen reinem Germanium und das zweite Target aus im wesentlichen reinem Silizium ist.

11. Verfahren gemäß Anspruch 1 oder 2, dadurch gekennzeichnet, daß das erste Target aus einem Element aus der Gruppe IVa des Periodischen Systems ist.

12. Verfahren gemäß Anspruch 1 oder 2, dadurch gekennzeichnet, daß das Substrat mit UV-Licht beleuchtet wird.

13. Verfahren gemäß Anspruch 1 oder 2, dadurch gekennzeichnet, daß das Substrat mit Elektronen bestrahlt wird.

14. Verfahren gemäß einem der vorstehenden Ansprüche, dadurch gekennzeichnet, daß die zweite Ionenquelle einen Strahl erzeugt, der Dotierungsionen umfaßt.

15. Verfahren gemäß Anspruch 14, dadurch gekennzeichnet, daß die Dotierungsionen Bor- oder Phosphorionen sind.

## Revendications

1. Procédé permettant de déposer un film semi-conducteur amorphe hydrogéné sur un substrat, ce procédé consistant simultanément à diriger des premier et deuxième faisceaux ioniques, produits respectivement par des première (5, 25, 45) et deuxième (9, 27, 47) sources d'ions, sur une première cible (13, 29, 53) en un matériau semi-conducteur qui doit être inclus dans le film, le premier faisceau ionique étant constitué d'ions de pulvérisation afin de pulvériser la matière à partir de la première cible et le second faisceau étant constitué d'ions hydrogène afin de réduire la densité des états localisés dans les films déposés, à recueillir les produits de pulvérisation arrivant, en provenance de la première cible, sur le substrat (15, 31, 57), et à régler de manière indépendante les courants et énergies relatifs des ions présents dans les premier et deuxième fasiceaux de façon telle que les ions de pulvérisation parviennent à pulvériser le matériau semi-conducteur à partir de la cible et de façon telle que l'énergie des ions hydrogène présents dans le deuxième faisceau ionique ne dépasse pas 200 électrons-volts.

2. Procédé suivant la revendication 1, caractérisé en ce que, tout en dirigeant les premier et deuxième faisceaux ioniques sur la première cible, on dirige simultanément des troisième et quatrième faisceaux ioniques, produits respectivement par des troisième (49) et quatrième (51) sources ioniques, sur une seconde cible (55) en un matériau semi-conducteur qui doit être inclus dans le film, cette seconde cible étant d'une composition différente de la première cible, le troisième faisceau ionique étant consitué d'ions de pulvérisation afin de pulvériser le matériau à partir de la deuxième cible et le quatrième faisceau étant constitué par des ions d'hydrogène afin de réduire la densité des états localisés dans les films déposés, à régler de manière indépendante les courants et énergies relatifs des ions présents dans les troisième et quatrième faisceaux de façon telle que les ions de pulvérisation parviennent à pulvériser le matériau semi-conducteur à partir de la seconde cible et de façon telle que l'énergie des ions hydrogène présents dans le quatrième faisceau ne dépassage pas 200 électrons-volts, et à recueillir, sur le substrat, les produits provenant des première et seconde cibles.

3. Procédé suivant la revendication 1 ou la revendication 2, caractérisé en ce que les ions de pulvérisation sont constitués par des ions d'argon.

4. Procédé suivant la revendication 3, caractérisé en ce que le faisceau ionique de pulvérisation ou au moins l'un des faisceaux ioniques de pulvérisation possède un courant compris entre 20 et 50 milliampères.

5. Procédé suivant la revendication 1 ou la revendication 2, caractérisé en ce que la première cible est constituée de silicium pratiquement pur.

6. Procédé suivant la revendication 5, caractérisé en ce que le faisceau ionique d'hydrogène ou au moins l'un des faisceaux ioniques d'hydrogène possède un courant compris entre 20 et 60 milliampères.

7. Procédé suivant la revendication 5 ou la revendication 6, caractérisé en ce qu'on élève la température du substrat à une valeur comprise entre 100°C et 300°C.

8. Procédé suivant la revendication 1, caractérisé en ce que la première cible est constituée par un alliage d'au moins deux semi-conducteurs élémentaires qui doivent être déposés sur le film.

9. Procédé suivant la revendication 8, caractérisé en ce que la première cible est constituée d'un alliage sensiblement pur de silicium et de germanium.

10. Procédé suivant la revendication 2, selon lequel la première cible est du germanium pratiquement pur et la deuxième·cible est du silicium pratiquement pur.

11. Procédé suivant la revendication 1 ou la revendication 2, selon lequel la première cible est constituée d'un élément du groupe IVa du tableau périodique.

12. Procédé suivant la revendication 1 ou la revendication 2, caractérisé en ce qu'on éclaire par de la lumière ultraviolette le substrat.

13. Procédé suivant la revendication 1 ou la revendication 2, caractérisé en ce qu'on bombarde d'électrons le substrat.

14. Procédé suivant l'une quelconque des revendications précédentes, caractérisé en ce que la deuxième source d'ions produit un faisceau constitué d'ions de dopage.

15. Procédé suivant la revendication 14, caractérisé en ce que les ions de dopage sont constitués d'ions de bore où de phosphore.

EP  0 177 115  B1

**Fig.1**

ABSORBANCE

B

A

2800    2000    1200    400

WAVENUMBER (CM-1)

2200    2000

B  A

**Fig.2**

EP 0 177 115 B1

Fig.3

Fig.4

_Fig. 5_

3

25

21

33

33

31

37

29

27

23

35

_Fig.6_

41

45

47

49

51

23

59

57

53

55

61

63

_Fig.7_

4